# EUROPEAN PATENT SPECIFICATION

(11) **EP 0 337 587 B1**
(45) Date of publication and mention of the grant of the patent: **29.03.1995**
(21) Application number: 89300166.9
(22) Date of filing: 10.01.1989
(51) Int. Cl.: G01N 24/08

(54) **Mri using asymmetric rf nutation pulses and asymmetric synthesis of complex conjugated se data to reduce te and t2 decay of nmr spin echo responses**
MR-Abbildung mit Hilfe asymmetrischer HF-Anregungspulse und asymmetrische Synthese komplexkonjugierter SE-Daten zur Reduzierung der TE- und T2-Abklingzeit von NMR-Spin-Echo-Signalen
IRM utilisant des impulsions haute fréquence asymétriques et une synthèse asymétrique de données complexes conjuguées d'écho de spin pour réduire la croissance TE et T2 des réponses d'échos de spin

(30) Priority: 14.04.1988 US 181386
(43) Date of publication of application: 18.10.1989
(73) Proprietor: THE REGENTS OF THE UNIVERSITY OF CALIFORNIA, Berkeley, California 94720 (US)
(72) Inventor: Yao, Ching, Belmont California 94002 (US)
(74) Representative: Pellmann, Hans-Bernd, Dipl.-Ing.

(56) References cited:
- GB-A- 2 176 012
- MAGNETIC RESONANCE IMAGING, vol. 5, supplement 1, 1987, 5TH Annual Meeting, San Antonio, Texas, 28th February-4th March 1987, pp. 102-103, D.D. STARK, Editor ; G. N. HOLLAND et al.: "Ultra short TE sequences"
- J. Magn. Res., vol. 77, 1988, pp. 175-181
- J. Magn. Res., vol. 74, 1987, pp. 226-263

## Description

This invention is generally related to magnetic resonance imaging (MRI) utilizing nuclear magnetic resonance (NMR) phenomena. It is more particularly directed to apparatus and method for practicing MRI so as to reduce or minimize the time-to-echo TE, thereby reducing T2 decay of the NMR RF spin echo response (and thus simultaneously saving data acquisition time and enhancing the potential signal-to-noise ratio of the resulting MRI image).

This application is related to the copending commonly assigned application of Yao et al filed concurrently herewith and entitled MRI COMPENSATED FOR SPURIOUS NMR FREQUENCY/PHASE SHIFTS CAUSED BY SPURIOUS CHANGES IN MAGNETIC FIELDS DURING NMR DATA MEASUREMENT PROCESSES.

MRI is now a widely accepted and commercially available technique for obtaining digitized visual images representing the internal structure of objects (such as the human body) having substantial populations of nuclei which are susceptible to NMR phenomena. In general, the MRI process depends upon the fact that the NMR frequency of a given nucleus is directly proportional to the magnetic field superimposed at the location of that nucleus. Accordingly, by arranging to have a known spatial distribution of magnetic fields (typically in a predetermined sequence) and by suitably analyzing the resulting frequency and phase of NMR RF responses (e.g., through multi-dimensional Fourier Transformation processes), it is possible to deduce a map or image of relative NMR responses as a function of the location of incremental volume elements (voxels) in space. By an ordered visual display of this data in a suitable raster scan on a CRT, a visual representation of the spatial distribution of NMR nuclei across a cross-section of an object under examination may be produced (e.g., for study by a trained physician).

In at least some typical NMR systems now commercially available (e.g., those available from Diasonics Inc.), one or more NMR spin echo RF responses are elicited from an imaged object volume by using a succession of slice-selective NMR RF pulses having shaped envelopes. For example, a slice-selective 90° RF nutation pulse may be utilized to selectively nutate NMR nuclei within a selected slice volume by substantially 90°. After a time delay, a slice-selective 180° RF nutation pulse is used to nutate those same nuclei by 180°. After an equal further time delay, the thus nutated NMR nuclei within the selected slice come back into phase with one another so as to emit a characteristic "spin echo" RF response. The total elapsed time from the initial 90° nutation to the occurrence of the envelope peak of the spin echo is typically referred to as the "time-to-echo" or "TE".

Unfortunately, the amplitude of such spin echo response is reduced by an exponential decay commonly referred to as the "T2" NMR parameter of the NMR nuclei. Accordingly, where NMR spin echo data is utilized for MRI, it has already been recognized that the signal-to-noise ratio of the measured spin echo signal can be enhanced by reducing or minimizing TE. Such signal-to-noise ratio is, of course, also a function of the total time window over which the spin echo RF response signal is actually measured (e.g., typically by digitized complex-valued samples of the RF waveform taken at approximately 10 to 30 microsecond intervals).

In addition to a possibly enhanced signal-to-noise ratio if TE can be reduced or minimized, it is also always preferable in MRI to minimize the required total data acquisition time. For example, it is typically necessary to repeatedly measure NMR responses several hundred times from a given slice volume in order to accumulate the requisite NMR response data required to produce a high resolution NMR image. Typically, several minutes or even tens of minutes may be required for an overall scan sequence. For reasons of economy as well as patient comfort and to also avoid possible image artifact (e.g., caused by moving elements within the image) or even to facilitate whole new MRI strategies, it is always a goal of MRI designers to minimize the overall required data acquisition time. This time saving may also be utilized to permit greater numbers of slice-volumes to be examined in a given TR interval.

Asymmetric sampling of a spin echo response has already been proposed by others. For example, see "Asymmetric Sampling IN 2DFT Magnetic Resonance Imaging" by Provost et al, Abstract presented at the August 1986 Meeting of the Society of Magnetic Resonance in Medicine. Here, the goal was to shift the center of the sampling window away from the center of the spin echo response in the time domain thus permitting a longer total duration of SE sampling -- with an attendant potential increase in the available signal-to-noise ration. It was also recognized that such asymmetric sampling of the spin echo response permitted reductions in TE for a given bandwidth.

It appears that Provost et al considered the asymmetrically sampled data merely to introduce a phase shift in the transform data which vanishes when the magnitude image is calculated. Actually, the Provost et al approach causes progressive loss of resolution as the asymmetry is increased. Provost et al do not consider the possibility of synthesizing the "missing" data so as to restore full resolution to the image.

Asymmetric RF nutation pulse envelopes have also been proposed in the past for certain purposes. See, for example:
Murdoch, et al, "Computer-Optimized Narrowband Pulses for Multislice Imaging", J. Mag. Res. 74, 226-263 (1987); and
Loaiza et al, "Selective Excitation Without Phase Distortion Using Self-Refocused Amplitude and Amplitude/Phase-Modulated Pulses", J. Mag. Res. 77, 175-181 (1988).

Murdoch et al propose asymmetric RF nutation pulses of a wide variety, e.g. sinc-like pulses, for the special purpose of achieving better slice volume definition (i.e. achieving NMR nutation/response from a slice volume having more precisely located "side walls"). Loaiza et al, an the other hand, also seek to minimize phase distortion without the need for separate phase correcting gradient pulses.

I have now discovered techniques for reducing TE (and hence reducing T2 decay) which involve the use of asymmetric RF nutation pulses combined with asymmetric synthesis of complex-conjugated spin echo data.

From document GB-A-2 176 012 a nuclear magnetic resonance imaging apparatus is known, wherein the signal-to-noise ratio is improved by means of using a Spin Echo method, i.e. measuring a spin echo signal and then Fourier-transforming this signal. That is, a 90° exciting pulse is impressed and a very short time after a 180° pulse for spin inversion is impressed; then sampling is performed with respect to spin echo signals to be generated asymmetrically the time after the impression of the 180° pulse to the collection of spins, and the time after the collection to the dispersion of the spin; finally assumed data previously lacking from a Fourier plane are interpolated and a Fourier transformation process is conducted by using such completed data, thereby providing a reconstituted image.

Furthermore, Magnetic Resonance Imaging, Vol. 5, Supplement 1, 1987, 5th Annual Meeting, San Antonio, Texas, 28th February - 4th March 1987, pages 102-103, D.D. Stark, editor; G.N. Holland et al.: "Ultra short TE sequences" discloses the use of TE as short as 10 ms without using additional hardware to design multiple slice, spin-echo sequences for improving the tissue contrast and, thereby enhancing the tumor detectability. Thus, RF pulse profiles which minimize the bandwidth per unit time of RF excitation are used and asymmetric sampling and conjugate symmetrization are used to minimize sampling prior to the echo maximum, thereby making possible a good signal-to-noise ratio.

However, I have discovered that, for example, it is possible to transmit at least one RF nutation pulse (e.g., a 90° nutation pulse) having an asymmetric envelope while still achieving the requisite NMR nuclei nutation (providing that its amplitude is suitably adjusted). If the asymmetry of the RF nutation pulse envelope(s) is properly directed, it facilitates a reduction in the minimum elapsed time interval between a succession of RF nutation pulses required to elicit a spin echo NMR RF response. It also facilitates reduced TE where gradient pulse reversals are used with a single RF pulse to recall an FID "spin echo". Accordingly, such asymmetry in one or more RF nutation pulses permits reduced or minimized TE with attendant reduction in T2 decay and enhancement of potential signal-to-noise ratio (which may, of course, be used in a tradeoff for improvement of other related NMR MRI parameters).

In conjunction with such asymmetric RF nutation pulse, I have also discovered that it is possible not only to merely asymmetrically sample the spin echo response and thus lengthen the actual duration of signal measurement (with attendant increases in potential signal-to-noise ratio) -- but that it is also possible to synthetically increase the effective time duration of sampling in the other direction by asymmetrically synthesizing complex-conjugated spin echo data (e.g., so as to reconstruct the spin echo signal which would occur if the spin system was allowed to evolve from the center of the echo backwards in time, with the RF pulses removed). Filling in this portion of the data is essential if full image resolution is to be realized.

By employing both types of asymmetric processes simultaneously, the TE can be substantially reduced and signal-to-noise increased with all of the expected attendant advantages mentioned above.

According to a first aspect of the present invention there is provided a magnetic resonance imaging system of the type which elicits NMR RF responses from an imaged object volume by using a slice-selective NMR RF pulse having a shaped envelope and by measuring the resulting NMR RF response during a sampling window, comprising: means, for receiving a spin echo NMR RF response, which results at least in part from said RF pulse, during a sampling window which is asymmetrically positioned in the time domain with respect to a maximum envelope peak in the spin echo, wherein said receiving means samples said NMR RF response asymmetrically in the time domain in a direction subsequent to said maximum envelope peak of the NMR RF response ; means for asymmetrically synthesizing spin echo response data not actually sampled by use of assumed complex conjugate symmetry so as to supply partly synthesized completed spin echo data representing a theoretical sampling window symmetrically positioned in the time domain about said envelope peak; characterized by means for causing said RF pulse to have an asymmetrically shaped envelope by being asymmetrically truncated between said RF pulse and said RF response so as to reduce T2 decay of the measured NMR RF response.

According to a second aspect of the present invention there is provided a method of reducing the T2-decay in a magnetic resonance imaging process of the type which elicits NMR RF spin echo responses from an imaged object volume by using a slice-selective NMR RF pulse having a shaped envelope and by measuring the resulting NMR RF response during a sampling window, wherein said RF pulse has an asymmetrically shaped envelope by being asymmetrically truncated between said RF pulse and said RF response so as to reduce the time-to-echo (TE) and thus reduce T2 decay of the measured NMR RF response.

These as well as other objects and advantages of this invention will be better appreciated and understood by carefully reading the following detailed description of a presently preferred exemplary embodiment, in conjunction with the accompanying drawings, of which:
FIGURE 1 is a generalized schematic block diagram of an MRI system modified so as to employ the presently preferred exemplary embodiment of this invention;
FIGURE 2 is a diagrammatic depiction of prior art MRI data gathering sequences:
FIGURE 3 depicts an exemplary modified NMR data gathering sequence which employs both an asymmetric 90° nutation pulse envelope and an asymmetric sampling window for the resulting spin echo response; and
FIGURE 4 depicts an exemplary modified NMR data gathering sequence which employs gradient reversal to generate the NMR RF response and which may optionally also include a subsequent inversion RF pulse to recall such response where asymmetry may be employed in the RF nutation pulse(s) and in the synthesis of RF response data.

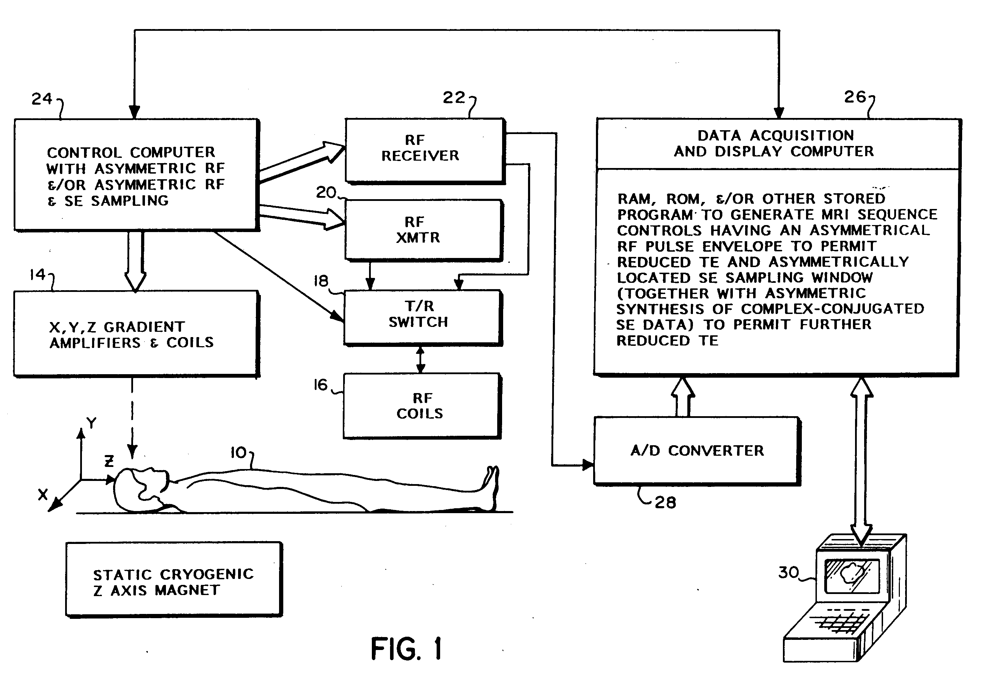

The novel signal processing and control procedures utilized in the exemplary embodiment typically can be achieved by suitable alteration of stored controlling computer programs in existing MRI apparatus. As one example of such apparatus, the block diagram of FIGURE 1 depicts the general architecture which may be employed in such a system.

Typically, a human or animal subject (or other object) 10 is inserted along the z-axis of a static cyrogenic magnet which establishes a substantially uniform magnetic field directed along the z-axis within the portion of the object of interest. Gradients are then imposed within this z-axis directed magnetic field along the x,y or z axes by a set of x,y,z gradient amplifiers and coils 14. NMR RF signals are transmitted into the body 10 and NMR RF responses are received from the body 10 via RF coils 16 connected by a conventional transmit/receive switch 18 to an RF transmitter 20 and RF receiver 22.

All of the prior mentioned elements may be controlled, for example, by a control computer system 24 which conventionally communicates with a data acquisition and display computer system 26. The latter computer 26 may also receive NMR RF responses via an analog-to-digital converter 28. A CRT display and keyboard unit 30 typically also is associated with the data acquisition and display computer 26.

As will be apparent to those in the art, such an arrangement may be utilized so as to generate desired sequences of magnetic gradient pulses and NMR RF pulses and to measure NMR RF responses in accordance with stored computer programs. As depicted in FIGURE 1, the MRI system of this invention will typically include RAM, ROM and/or other stored program media adapted (in accordance with the following descriptions) so as to generate sequence controls (either via computer 26 or directly in control computer 24) having an asymmetrical RF pulse envelope to permit reduced TE and asymmetrically located SE sampling windows (with associated asymmetric synthesis of conjugated SE data). The resulting, partly synthesized (spin echo data) may then be conventionally processed (e.g., via multi-dimensional Fourier Transformation) into final high resolution NMR images.

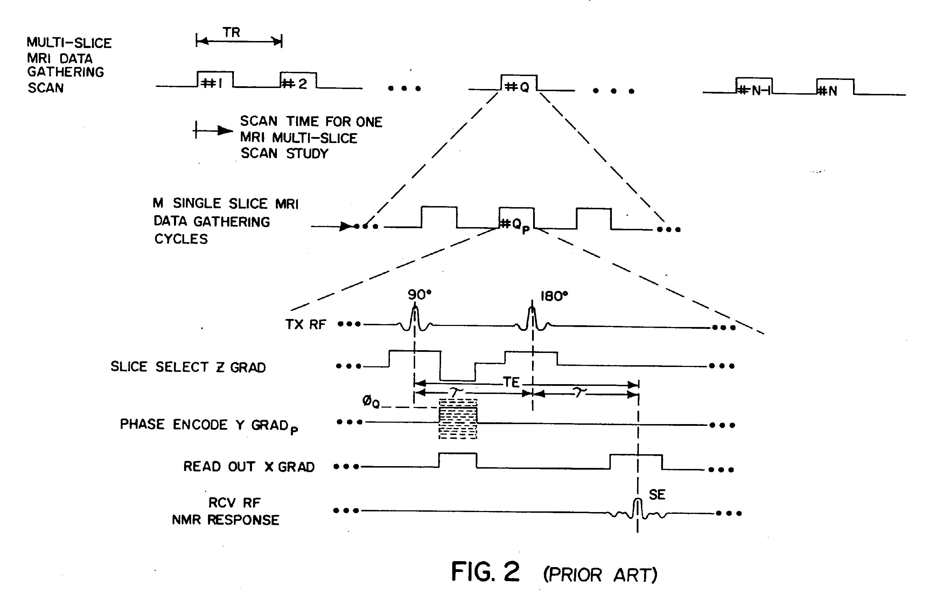

FIGURE 2 depicts a typical prior art data acquisition sequence. Here, a single MRI data gathering scan or "study" involves a number N (e.g., 128 or 256) of successive data gathering cycles. In fact, if, as depicted in FIGURE 2, a multi-slice scan is involved, then each of the N events comprising a single scan or "study" may actually comprise M single slice MRI data gathering cycles. In any event, for a given single slice data gathering cycle p, a slice selection z-axis gradient pulse (and associated phase correction pulse) may be employed to selectively address a transmitted 90° RF nutation pulse into a slice volume centered about the center frequency of the transmitted RF signal and of sufficient magnitude and duration so as to nutate a substantial population of nuclei within the selected slice-volume by substantially 90°. Thereafter, a y-axis gradient pulse is employed (of magnitude φ_{Q} for this particular cycle and varying between maximum magnitudes of both polarities over the N data gathering cycles for that particular slice).

After a predetermined elapsed time, a 180° RF NMR nutation pulse will be transmitted selectively to the same slice volume (via application of the appropriate z-axis gradient). In accordance with the "rule of equal times," a true spin echo signal SE evolves after a further similar elapsed time. During the recordation of the RF NMR response signal (where amplitude and phase of RF is measured at successive sample points), a readout x-axis magnetic gradient is employed so as to provide spatial frequency encoding in the x-axis dimension. Additional spin echo responses can also be elicited by the use of additional 180° nutation pulses or suitable other techniques -- albeit they will of decayed amplitude due to the NMR T2 decay.

The time-to-echo TE is depicted in FIGURE 2 as is the repetition time TR parameter. As just explained, TE interacts with the T2 NMR exponential decay parameter to reduce signal amplitude. The TR interacts with the T1 NMR exponential recovery parameter so that one generally has to wait for substantial relaxation of previously excited nuclei before the next measurement cycle of the same volume can begin.

It will be noted that during each RF excitation pulse, there is a slice selection G_{z} magnetic gradient pulse switch "on" so as to selectively excite only the desired "slice" or "planar volume" (e.g., a slice of given relatively small thickness such as 5 or 10 millimeters through the object being imaged). During each resulting spin echo NMR RF response, x-axis phase encoding is achieved by applying an x-axis magnetic gradient during the readout procedure (typically each spin echo pulse is sampled every 30 microseconds or so with digitized sample point complex valued data being stored for later signal processing).

As depicted in FIGURE 2, it will be understood that, in practice, the number of measurement cycles typically is equal to the number of desired lines of resolution along the y-axis in the final image (assuming that there is no data synthesis via conjugation processes). After a measurement cycle is terminated with respect to a given "slice," it is allowed to relax for a TR interval (usually on the order of relaxation time T1) while other "slices" are similarly addressed so as to obtain their spin echo responses. Typically, on the order of hundreds of such measurement cycles are utilized to obtain enough data to provide hundreds of lines of resolution along the y-axis dimension. A sequence of N such y-axis phase encoded spin echo signals is then typically subjected to a two-dimensional Fourier Transformation process to result in an N x N array of pixel values for a resulting NMR image in a manner that is by now well understood in the art.

The data set generated in a standard 2DFT NMR imaging sequence possesses a so-called Hermitian symmetry. This implies, in principle, that only one-half of a complete data set need be acquired since the other half can be derived subsequently through a simple operation of complex-conjugation mapping. Such data synthesis techniques are by now well-known in the art and are described, for example, in issued US patent number 4,728,893 - Feinberg (commonly assigned with the present application).

If such data synthesis techniques are employed, the entire spin echo no longer needs to be developed within the actual time domain sampling window used to measure the spin echo response. This does away with one constraint which otherwise limits the minimum TE (and/or sampling bandwidth).

In practice, there are many factors which affect and destroy the theoretically exact symmetry which should be present. One dominant factor in a well-shimmed superconducting magnet, for example, may be a phase error caused by an induced eddy current field (e.g., induced by the strong slice-selection gradient pulses G_{z}). The extra phase modulation of the eventual SE caused by remnant eddy current fields can be measured in one or more extra "calibration" cycle(s) (e.g., by avoiding phase encoding G_{y} and readout Gₓ gradients) with the phase of this resulting calibration data being used to correct the acquired image data set. Such correction for spurious magnetic fields changes are described in more detail, for example, in the above-referenced related copending commonly assigned application.

Another factor which degrades the symmetry somewhat is T2 decay over the SE sample window. However this source of error is sufficiently small that it does not eliminate the benefits of data synthesis by conjugation techniques.

It will be noted in FIGURE 2 that both the 90° and 180° RF nutation pulses have envelopes which are symmetrically truncated sinc-like shapes. For example, in one typical prior art embodiment, a truncated approximately sinc-shaped RF pulse envelope was used which extends for ten zero crossings (i.e. five to each side of the peak). The same envelope shape was used for both the 90° nutation pulse and the 180° nutation pulse -- except that the 180° nutation pulse has an amplitude which is twice that of the 90 degree nutation pulse. Typically, the duration of such pulses is inversely proportional to the thickness of the slice-volume which is being imaged. For thin slices, the duration of the required RF nutation pulses may be adversely long (e.g., meaning that the minimum TE time is correspondingly lengthened thus increasing the exponential loss of measured SE response due to T2 NMR relaxation effects).

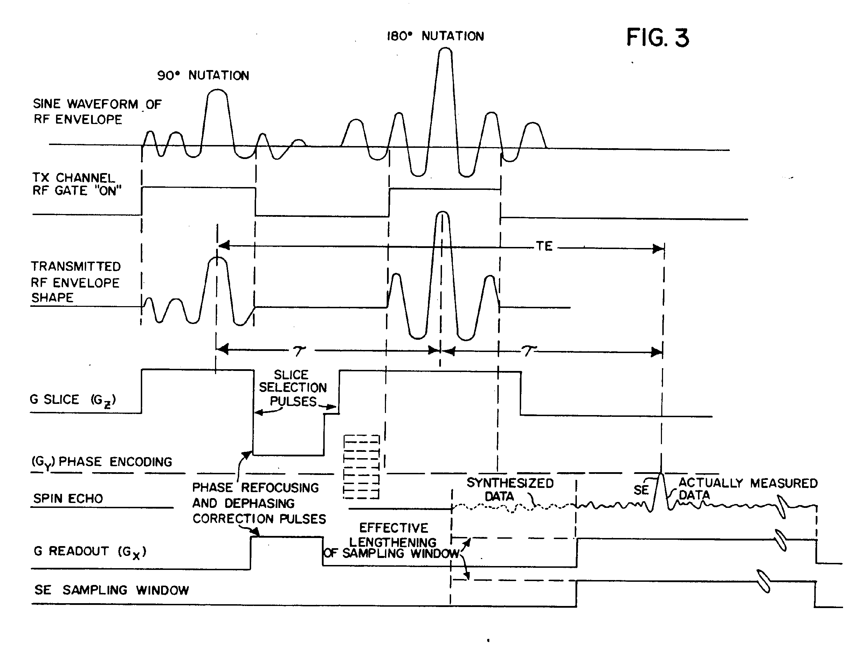

Accordingly, especially for thin slices, a different approach is proposed in the exemplary embodiment of this invention as depicted in FIGURE 3. Here, an asymmetrically shaped envelope is used for the 90° nutation pulse and a six (total) zero crossing 180° RF nutation pulse is used (with a symmetrically shaped sinc-like envelope). By appropriately directing the asymmetry of the 90° nutation pulse (i.e., to truncate envelope portions extending towards the subsequent 180° pulse as depicted in FIGURE 3), the necessary time between the 90° and 180° RF pulses (e.g., for gradient phase refocusing and de-phasing) can be provided while still decreasing the minimum time delay interval before 180° nutation -- and thus the time interval TE. Calculations can be made to show that the 90° and 180° pulse pair shown in FIGURE 3 still provide the necessary NMR nuclei nutations so as to produce the requisite spin echo response (so long as the amplitude of the asymmetrically truncated sinc envelope is adjusted to provide the same included area thereunder as was previously used with the symmetrically truncated envelope) without significant degradation to the profile of the slice-volume being imaged.

At the same time, somewhat similar to the prior art suggestion of Provost et al (referenced earlier) the preferred exemplary embodiment utilizes asymmetric sampling of the spin echo. That is, the sampling window is asymmetrically situated with respect to the peak of the spin echo envelope. The asymmetric positioning of the sampling window itself, of course, permits the actual sampling window to be extended significantly in the direction away from the 180° pulse in FIGURE 3 so as to extend the total duration of the sampling window in accordance with prior art teachings such as Provost et al.

However, in addition, in the preferred exemplary embodiment, synthesized data (using complex-conjugate synthesis) is asymmetrically generated as depicted in FIGURE 3 so as to fill in only the "missing" asymmetric portions of the asymmetrically sampled spin echo response data. In this manner, a complete composite spin echo response data set is provided which appears to be symmetric -- albeit an asymmetric portion of this data set actually comprises synthesized data. By minimizing the amount of data in the complete final data set that has been synthesized, errors caused by synthesis are similarly minimized.

Since the typically available conventional MRI systems already include programmable gates for gating "on" and "off" RF nutation pulses (as well as shaping such pulses into desired sinc-shapes or otherwise) and for gating "on" and "off" desired magnetic gradient pulses, the occurrence of spin echo sampling windows, etc., implementation of the exemplary embodiment depicted in FIGURE 3 requires only that sequencing control programs (e.g., in control computer 24 and/or associated computer systems 26) be suitably programmed so as to control the gating elements differently. Accordingly, such reprogramming is believed to be well within the ordinary skill of those working in this art and no further description is believed to be necessary.

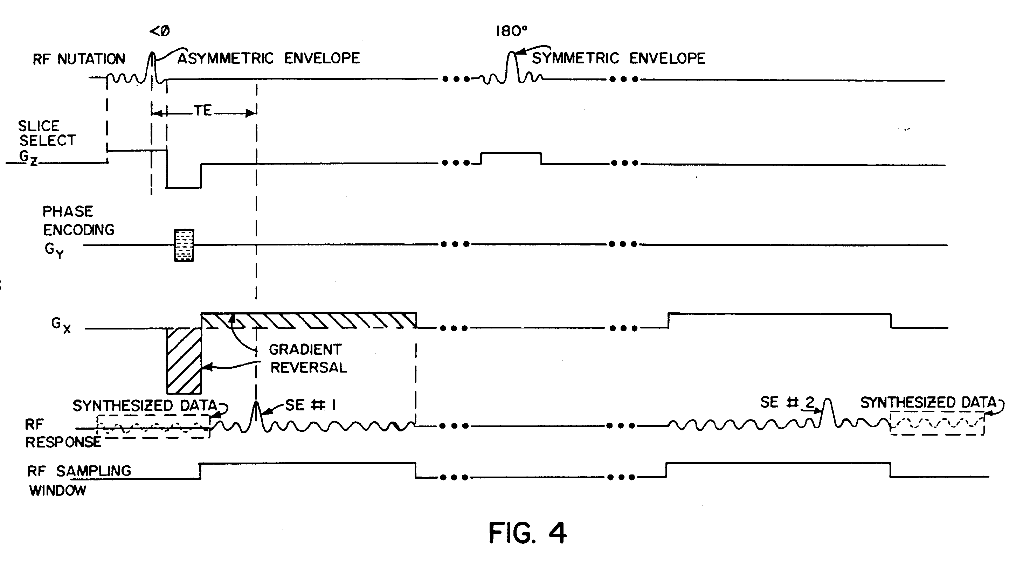

Another examplary embodiment is depicted in FIGURE 4. Here known gradient reversal techniques are used to recall an FID-type of spin echo at a time TE after an initial RF nutation pulse (which may purposefully be kept to a relatively small nutation angle so as to facilitate short TR). Here an asymmetric Gₓ gradient reversal and an asymmetric initial RF nutation pulse envelope may be used to reduce TE. In addition, asymmetric SE sampling coupled with asymmetric synthesis of the "missing" SE data may be employed as in the earlier described examplary embodiment.

In addition, if desired (e.g. to measure T2 and/or to increase S/N ratio), a subsequent slice selective 180 degree RF nutation pulse may be employed to recall the spin echo. Here the second spin echo may also be asymmetrically sampled -- but in an opposite direction (as shown in FIGURE 4) so as to minimize required TR. The asymmetrically synthesized data is similarly synthesized in an opposite time direction so as to "fill in" the missing SE data and to provide a complete composite data set representing a symmetrical SE.

In another non-illustrated version of the FIGURE 4 embodiment, the first spin echo could be recalled with a 180 degree RF nutation pulse instead of a gradient reversal. In this case, the first and second spin echoes would constitute true spin echoes in even the most strict sense.

As will be recognized, the use of asymmetric RF nutation pulses may find application in a diverse assortment of MRI systems employing many different types of NMR measurement sequences (including those which rely on FID rather than or in addition to SE responses and those using only single RF nutation pulses).

While only one exemplary embodiment has been described in detail, those skilled in the art will recognize that many variations and modifications may be made in the exemplary embodiment while still retaining many of the novel features and advantages of this invention. Accordingly, all such variations and modifications are intended to be included within the scope of the appended claims.

## Claims

1. A magnetic resonance imaging system of the type which elicits NMR RF responses from an imaged object volume by using a slice-selective NMR RF pulse having a shaped envelope and by measuring the resulting NMR RF response during a sampling window, comprising:
means (16, 18, 22, 24, 26) for receiving a spin echo NMR RF response, which results at least in part from said RF pulse, during a sampling window which is asymmetrically positioned in the time domain with respect to a maximum envelope peak in the spin echo, wherein said receiving means (22) samples said NMR RF response asymmetrically in the time domain in a direction subsequent to said maximum envelope peak of the NMR RF response ;
means (26) for asymmetrically synthesizing spin echo response data not actually sampled by use of assumed complex conjugate symmetry so as to supply partly synthesized completed spin echo data representing a theoretical sampling window symmetrically positioned in the time domain about said envelope peak; characterized by means (24) for causing said RF pulse to have an asymmetrically shaped envelope by being asymmetrically truncated between said RF pulse and said RF response so as to reduce T2 decay of the measured NMR RF response.

2. A magnetic resonance imaging system according to claim 1, wherein
said means for causing the RF pulse to have an asymmetrically shaped envelope includes means (24, 20) for generating and transmitting including:
means (24) for generating NMR RF pulses having approximately sinc-shaped envelopes;
means (24) for generating and transmitting a first nutation NMR RF pulse having a sinc-shaped envelope truncated asymmetrically;
means (14, 24) for generating a magnetic gradient pulse to refocus the NMR spins subsequent to said first nutation pulse; and
means (24) for generating and transmitting a subsequent 180° nutation NMR RF pulse having an approximately sincshaped envelope truncated symmetrically.

3. A method of reducing the T2-decay in a magnetic resonance imaging process of the type which elicits NMR RF spin echo responses from an imaged object volume by using a slice-selective NMR RF pulse having a shaped envelope and by measuring the resulting NMR RF response during a sampling window, wherein said RF pulse has an asymmetrically shaped envelope by being asymmetrically truncated between said RF pulse and said RF response so as to reduce the time-to-echo (TE) and thus reduce T2 decay of the measured NMR RF response.

4. A method according to claim 3, further comprising:
causing the sampling window to be asymmetrically positioned in the time domain with respect to a maximum envelope peak in the NMR RF response; and
asymmetrically synthesizing pseudo NMR RF response data not actually measured so as to supply complete, partly synthesized, NMR RF data representing a theoretical sampling window symmetrically positioned about said maximum envelope peak.

5. A method according to claim 3, further comprising:
receiving a spin echo NMR RF response during a sampling window which is asymmetrically positioned in the time domain with respect to a maximum envelope peak in the spin echo; and
asymmetrically synthesizing spin echo response data not actually sampled by use of assumed complex conjugate symmetry so as to supply partly synthesized complete spin echo data representing a theoretical sampling window symmetrically positioned in the time domain about said maximum envelope peak.

6. A method according to claim 5, further including the steps of:
generating and transmitting a first nutation NMR RF pulse having a sinc-shaped envelope truncated asymmetrically; and
generating and transmitting a subsequent 180° nutation NMR RF pulse having a sinc-shaped envelope truncated symmetrically.

## Patentansprüche

1. Magnetisches Resonanzabbildungssystem der Art, das NMR-Hochfrequenz-Antworten von einem abgebildeten Körpervolumen unter Verwendung eines Scheibenauswahl-NMR-Hochfrequenzimpulses mit einer geformten Hüllkurve und durch Messen der resultierenden NMR-Hochfrequenz-Antwort während eines Abtastfensters hervorbringt, mit:
einer Einrichtung (16, 18, 22, 24, 26) zum Empfangen einer Spin-Echo-NMR-Hochfrequenz-Antwort, die sich zumindest teilweise aus dem Hochfrequenzimpuls ergibt, während eines Abtastfensters, das im Zeitbereich in Bezug auf eine maximale Hüllkurvenspitze beim Spin-Echo asymmetrisch angeordnet ist, wobei die Empfangseinrichtung (22) die NMR-Hochfrequenz-Antwort asymmetrisch im Zeitbereich in einer der maximalen Hüllkurvenspitze der NMR-Hochfrequenz-Antwort nachfolgenden Richtung abtastet;
einer Einrichtung (26) zum asymmetrischen Zusammenfügen von Spin-Echo-Antwortdaten, die nicht tatsächlich abgetastet sind, unter Verwendung einer vorausgesetzten konjugiert-komplexen Symmetrie, um teilweise zusammengefügte vervollständigte Spin-Echo-Daten zu liefern, die ein im Zeitbereich symmetrisch um die Hüllkurvenspitze angeordnetes theoretisches Abtastfenster darstellen;
**gekennzeichnet durch**
eine Einrichtung (24), die den Hochfrequenzimpuls durch asymmetrisches Abschneiden zwischen dem Hochfrequenzimpuls und der Hochfrequenzantwort in eine asymmetrisch geformte Hüllkurve bringt, um einen T2-Abfall der gemessenen NMR-Hochfrequenzantwort zu verringern.

2. Magnetisches Resonanzabbildungssystem nach Anspruch 1,
**dadurch gekennzeichnet, daß**
die Einrichtung, die den Hochfrequenzimpuls in eine asymmetrisch geformte Hüllkurve bringt, eine Einrichtung (24, 20) zum Erzeugen und Übertragen umfaßt, mit:
einer Einrichtung (24) zum Erzeugen von NMR-Hochfrequenzimpulsen mit annähernd sinusförmigen Hüllkurven;
einer Einrichtung (24) zum Erzeugen und Übertragen eines ersten Nutations-NMR-Hochfrequenzimpulses mit einer sinusförmigen, asymmetrisch abgeschnittenen Hüllkurve;
einer Einrichtung (14, 24) zum Erzeugen eines magnetischen Gradientenimpulses zum Refokussieren der dem ersten Nutationsimpuls nachfolgenden NMR-Spins; und
einer Einrichtung (24) zum Erzeugen und Übertragen eines nachfolgenden 180°-Nutations-NMR-Hochfrequenzimpulses mit einer annähernd sinusförmigen, Symmetrisch abgeschnittenen Hüllkurve.

3. Verfahren zum Verringern des T2-Abfalls bei einem magnetischen Resonanzabbildungsverfahren der Art, das NMR-Hochfrequenz-Spin-Echo-Antworten von einem abgebildeten Körpervolumen unter Verwendung eines Scheibenauswahl-NMR-Hochfrequenzimpulses mit einer geformten Hüllkurve und durch Messen der resultierenden NMR-Hochfrequenzantwort während eines Abtastfensters erzeugt,
**dadurch gekennzeichnet, daß**
der Hochfrequenzimpuls eine durch asymmetrisches Abschneiden zwischen dem Hochfrequenzimpuls und der Hochfrequenzantwort gebildete, asymmetrisch geformte Hüllkurve besitzt, um die Echozeit (TE) zu verringern und somit den T2-Abfall, der gemessenen NMR-Hochfrequenzantwort zu verringern.

4. Verfahren nach Anspruch 3,
das weiter umfaßt:
asymmetrisches Positionieren des Abtastfensters im Zeitbereich in Bezug auf eine maximale Hüllkurvenspitze bei der NMR-Hochfrequenzantwort; und
asymmetrisches Zusammenfügen nicht wirklich gemessener Pseudo-NMR-Hochfrequenzantwortdaten, um vollständige, teilweise zusammengefügte, NMR-Hochfrequenzdaten zu liefern, die ein symmetrisch um die maximale Hüllkurvenspitze angeordnetes, theoretisches Abtastfenster darstellen.

5. Verfahren nach Anspruch 3,
das weiter umfaßt:
Empfangen einer Spin-Echo-NMR-Hochfrequenzantwort während eines Abtastfensters, das im Zeitbereich in Bezug auf eine maximale Hüllkurvenspitze beim Spin-Echo asymmetrisch angeordnet ist; und
asymmetrisches Zusammenfügen von nicht wirklich abgetasteten Spin-Echo-Antwortdaten unter Verwendung einer vorausgesetzten konjugiert-komplexen Symmetrie, um teilweise zusammengefügte vollständige Spin-Echo-Daten zu liefern, die ein im Zeitbereich symmetrisch um die maximale Hüllkurvenspitze angeordnetes theoretisches Abtastfenster darstellen.

6. Verfahren nach Anspruch 5,
wobei das Verfahren weiterhin die Schritte umfaßt:
Erzeugen und Übertragen eines ersten Nutations-NMR-Hochfrequenzimpulses mit einer sinusförmigen, asymmetrisch abgeschnittenen Hüllkurve;
und
Erzeugen und Übertragen eines nachfolgenden 180°-Nutations-NMR-Hochfrequenzimpulses mit einer sinusförmigen, symmetrisch abgeschnittenen Hüllkurve.

## Revendications

1. Système d'imagerie à résonance magnétique du type qui obtient des réponses HF à résonance magnétique nucléaire à partir d'un volume d'objets formé en image en utilisant une impulsion HF à résonance magnétique nucléaire de sélection de tranche ayant une enveloppe mise en forme et en mesurant la réponse HF à résonance magnétique nucléaire résultante pendant une fenêtre d'échantillonnage, comprenant :
un moyen (16, 18, 22, 24, 26) pour recevoir une réponse HF à résonance magnétique nucléaire d'écho de spin, qui résulte au moins en partie de ladite impulsion HF, pendant une fenêtre d'échantillonnage qui est positionnée asymétriquement dans le temps par rapport à une crête maximale d'enveloppe de l'écho de spin,
dans lequel ledit moyen de réception (22) échantillonné ladite réponse HF à résonance magnétique nucléaire asymétriquement dans le temps dans un sens qui suit ladite crête maximale d'enveloppe de la réponse HF à résonance magnétique nucléaire,
un moyen (26) pour synthétiser asymétriquement les données de réponse d'écho de spin non réellement échantillonnées par l'utilisation d'une symétrique complexe conjuguée supposée, de façon à délivrer des données d'écho de spin recomplétées partiellement synthétisées représentant une fenêtre d'échantillonnage théorique symétriquement positionnée dans le temps par rapport à ladite crête d'enveloppe,
caractérisé par
un moyen (24) pour amener ladite impulsion HF à avoir une enveloppe de forme asymétrique en étant asymétriquement tronquée entre ladite impulsion HF et ladite réponse HF de façon à réduire l'amortissement T2 de la réponse HF à résonance magnétique nucléaire mesurée.

2. Système d'imagerie à résonance magnétique selon la revendication 1, dans lequel ledit moyen pour amener l'impulsion HF à avoir une enveloppe de forme asymétrique comporte un moyen (24, 20) pour la production et l'émission comportant :
un moyen (24) pour produire des impulsions HF à résonance magnétique nucléaire ayant des enveloppes approximativement de forme sinusoïdale,
un moyen (24) pour produire et émettre une première impulsion HF à résonance magnétique nucléaire de nutation ayant une enveloppe de forme sinusoïdale tronquée asymétriquement,
un moyen (14, 24) pour produire une impulsion de gradient magnétique afin de refocaliser les spins à résonance magnétique nucléaire ultérieurs à ladite première impulsion de nutation, et
un moyen (24) pour produire et émettre une impulsion de fréquence à résonance magnétique nucléaire de nutation à 180° ultérieure ayant une enveloppe de forme approximativement sinusoïdale tronquée symétriquement.

3. Procédé pour réduire l'amortissement T2 dans un procédé d'imagerie à résonance magnétique du type qui obtient des réponses d'écho de spin HF à résonance magnétique nucléaire à partir d'un volume d'objet formé en image par l'utilisation d'une impulsion HF à résonance magnétique nucléaire de sélection de tranche ayant une enveloppe mise en forme, et en mesurant la réponse HF à résonance magnétique nucléaire obtenue pendant une fenêtre d'échantillonnage, dans lequel ladite impulsion HF présente une enveloppe de forme asymétrique en étant tronquée asymétriquement entre ladite impulsion HF et ladite réponse HF de façon à réduire le temps à l'écho (TE) et réduire ainsi l'amortissement T2 de la réponse HF à résonance magnétique nucléaire mesurée.

4. Procédé selon la revendication 3, comprenant de plus les étapes consistant à :
amener la fenêtre d'échantillonnage à être asymétriquement positionnée dans le temps par rapport à une crête maximale d'enveloppe de la réponse HF à résonance magnétique nucléaire, et
synthétiser asymétriquement les pseudo données de réponse HF à résonance magnétique nucléaire non réellement mesurées de façon à délivrer des données HF à résonance magnétique nucléaire complètes, partiellement synthétisées, représentant une fenêtre d'échantillonnage théorique positionnée symétriquement par rapport à ladite crête maximale d'enveloppe.

5. Procédé selon la revendication 3, comprenant de plus les étapes consistant à :
recevoir une réponse HF à résonance magnétique nucléaire d'écho de spin pendant une fenêtre d'échantillonnage qui est asymétriquement positionnée dans le temps par rapport à une crête maximale d'enveloppe de l'écho de spin, et
synthétiser asymétriquement les données de réponse d'écho de spin non réellement échantillonnées par l'utilisation d'une symétrie supposée complexe conjuguée de façon à délivrer des données d'écho de spin complètes partiellement synthétisées représentant une fenêtre d'échantillonnage théorique symétriquement positionnée dans le temps par rapport à ladite crête maximale d'enveloppe.

6. Procédé selon la revendication 5, comportant de plus les étapes consistant à :
produire et émettre une première impulsion HF à résonance magnétique nucléaire de nutation ayant une enveloppe de forme sinusoïdale tronquée asymétriquement, et
produire et émettre une impulsion suivante HF à résonance magnétique nucléaire de nutation à 180° ayant une enveloppe de forme sinusoïdale tronquée symétriquement.
